Europäisches Patentamt

European Patent Office

Office européen des brevets

(11) Publication number : **0 562 783 A1**

# EUROPEAN PATENT APPLICATION

(21) Application number : **93302118.0**

(22) Date of filing : **19.03.93**

(51) Int. Cl.⁵ : **H01L 21/324, H01L 21/322**

(30) Priority : **24.03.92 JP 96064/92**

(43) Date of publication of application :
**29.09.93 Bulletin 93/39**

(84) Designated Contracting States :
**DE FR GB**

(71) Applicant : **SHIN-ETSU HANDOTAI COMPANY LIMITED**
**4-2, Marunouchi 1-Chome**
**Chiyoda-ku Tokyo (JP)**

(72) Inventor : **Hayamizu,Yoshinori**
**791-4 Yanase**
**Annaka-shi,Gunma-Ken (JP)**
Inventor : **Ushio,Satoshi**
**117 Yanashe**
**Annaka-shi,Gunma-Ken (JP)**
Inventor : **Takenaka,Takao**
**1673-1 Haraichi**
**Annaka-shi,Gunma-Ken (JP)**

(74) Representative : **Pacitti, Pierpaolo A.M.E. et al**
**Murgitroyd and Company 373 Scotland Street**
**Glasgow G5 8QA (GB)**

(54) **A method for heat treating a silicon wafer.**

(57) A method for heat treating a single crystal silicon wafer whose back face is covered with a polycrystal silicon film comprising the steps of : heating the wafer at a temperature substantially higher than 800°C in an inert atmosphere, and then either (i) cooling the wafer at a rate of less than about 3°C per minute to a temperature selected from a range of about 400°C to about 800°C or (ii) the silicon wafer is kept at a temperature selected from a range of about 400°C to about 800°C for a predetermined period of time.

EP 0 562 783 A1

## Background of the Invention

The present invention relates to a method for heat treating a single crystal silicon wafer whose back face is covered with a polycrystal silicon film (hereinafter merely referred to as "PBS wafer").

## Description of the Prior Art

Impurities contained in a silicon wafer such as heavy metals tend to deteriorate the properties of the devices made from the wafer, so that it is necessary to remove such impurities. According to one of well-known methods for impurity removal, a polycrystal silicon film is laid on the back face of a silicon wafer by means of a conventional CVD technique, and this silicon wafer backed with the polycrystal silicon film (hereinafter merely referred to as "polysilicon film") is subjected to a heat treatment whereby such heavy metals as Cu and Ni are absorbed by the polysilicon film, that is, the impurities are removed from the single crystal silicon wafer by the gettering effect of the polysilicon.

## Problems the Invention seeks to solve

According to the above method, it was possible to easily remove heavy metals from the silicon wafer such as Cu and Ni, through the gettering effect of the polysilicon, and it has been confirmed that the cooling rate of the wafer after the heat treatment greatly affects the gettering result. However, when it comes to metals of low diffusion coefficients such as iron (Fe), even this conventional method could not attain effective gettering result. Now, it has been expected that a method will be invented wherein the grain diameter and thickness of the polysilicon film of the PBS wafer are considered and the heat treatment conditions are novel, so that it would become possible to attain effective gettering removal of Fe; however, there has not been known any invention that enables effective Fe gettering.

The present invention was made in view of these problems, and it is, therefore, an object of the invention to provide a silicon wafer heat treating method which enables effective Fe gettering and thus enables substantial lowering of the Fe concentration in the silicon wafer.

## SUMMARY OF THE INVENTION

### Means to solve the Problems

In order to attain the above object of the invention, there is provided a method of heat treating a single crystal silicon wafer whose back face is covered with a polycrystal silicon film which method comprises the steps of: (a) heating the wafer at a temperature substantially higher than 800°C in an inert atmosphere, and (b) cooling the wafer to a temperature selected from a range of about 400°C to about 800°C.

According to one aspect of the invention, the silicon wafer is cooled to the selected temperature (which is preferably from about 400°C to about 600°C) at a rate of less than about 3°C per minute.

According to another aspect of the invention, the silicon wafer is kept at the selected temperature (which is preferably from about 400°C to about 700°C) for a predetermined period of time.

Preferably, the said predetermined time period is such that the value of $(D \cdot t)^{1/2}$ is either roughly equal to or greater than the thickness of the silicon wafer, wherein D is the diffusion coefficient of iron and t is the said predetermined time period.

## Effects

As the present inventors analyzed the mechanism of gettering by means of the polysilicon film, they estimated the temperature at which Fe gettering is initiated, that is, the temperature at which iron starts separating in the polysilicon film (critical temperature). Parameters required for this estimation are temperature dependency of the Fe diffusion coefficient in Si, cooling rate of the silicon wafer, and the amount of Fe involved in the gettering. Calculations were conducted based on these parameters, and as the result, the inventors obtained 710°C as the estimated critical temperature for Fe separation to start. This means that substantial Fe gettering occurs only when the temperature is 710°C or lower.

The inventors tried to verify the precision of the estimation (710°C) of the Fe separation temperature through experiments, and, as the result, found that separation of iron proceeds at temperature not higher than 710 ± 10°C; although it was observed that certain modicum degree of gettering had taken place in a PBS wafer which was fetched out from the furnace at a temperature exceeding 800°C.

Therefore, according to the first aspect of the invention, the PBS wafer is gradually cooled at a cooling rate of lower than about 3°C per minute to a temperature selected from the range of from about 400 °C to about 800°C (preferably lower than the vicinity of 710°C) before being fetched out from the furnace, and according to the second aspect of the invention, the PBS wafer is kept at a temperature selected from the range of from about 400°C to about 800 °C (preferably lower than the vicinity of 710°C) before being fetched out from the furnace, so that it is now possible to cause Fe gettering effectively, and it is also possible to control the Fe concentration in the silicon wafer through arbitrary selection of the temperature at which the wafer is fetched out after the cooling, or the temperature at which the wafer is kept heated.

These and other objects and many of the attendant advantages of this invention will be readily appreciated as the same becomes better understood by reference to the following detailed description when considered in connection with the accompanying drawing.

*Brief Description of the Drawings*

Fig. 1 is a graph showing a temperature variation with time in the heat treatment according to the first embodiment of the invention.

Fig. 2 is a graph showing a down-ward curve along which the intra-furnace temperature falls with time after the power supply to the horizontal furnace used in the first embodiment is cut off when the temperature is 900°C.

Fig. 3 is a graph showing a relation between gettering efficiency and fetching temperature.

Fig. 4 is a graph showing an example of the temperature variation with time in the heat treatment according to the second embodiment of the invention.

Fig. 5 is a graph showing a relation between gettering efficiency and retention temperature.

*Embodiment*

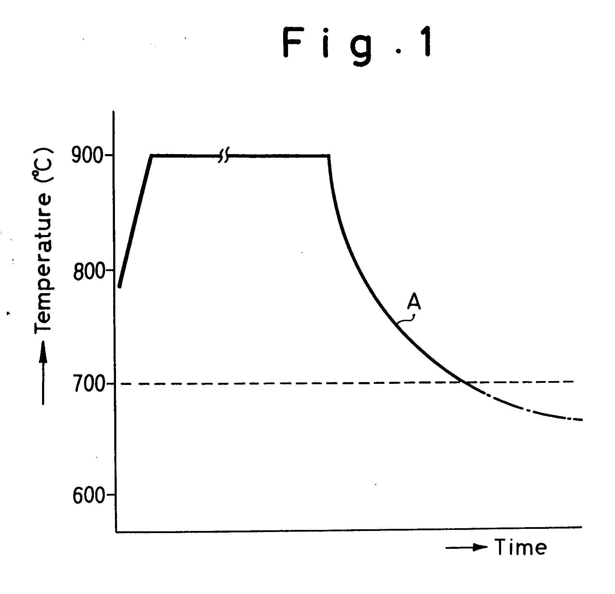

Next, a first embodiment of the invention will be described with reference to Figs. 1 through 3.

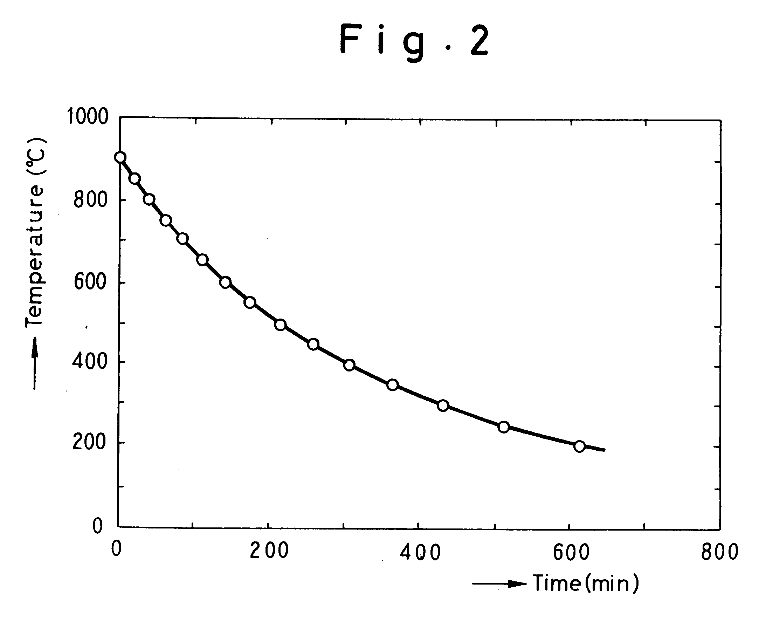

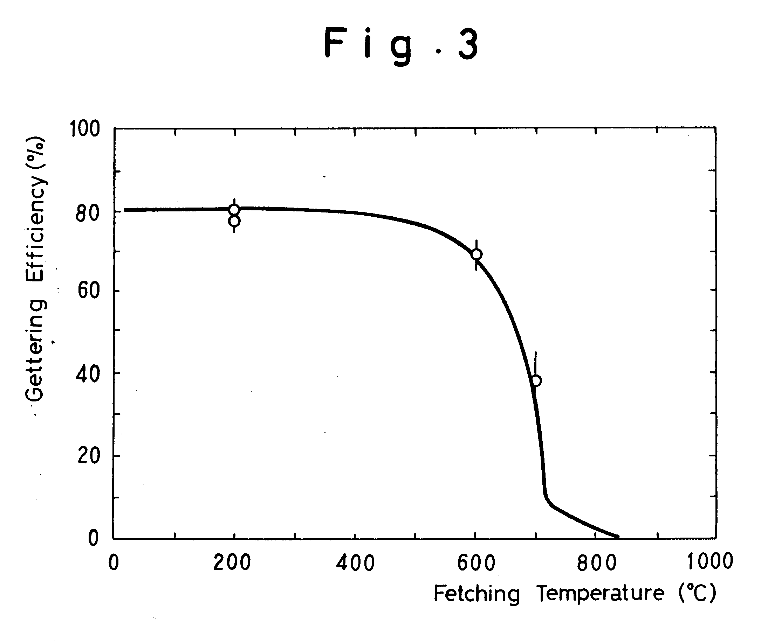

Fig. 1 is a graph showing a temperature variation with time in the heat treatment according to the first embodiment of the invention; Fig. 2 is a graph showing a down-ward curve along which the intra-furnace temperature falls with time in the case where the horizontal furnace used in this embodiment is switched off when the temperature is 900°C; and Fig. 3 is a graph showing a relation between gettering efficiency and fetching temperature.

Commonly, a PBS wafer is obtained by forming a polysilicon film on the back face of a silicon wafer by means of the CVD technique. In the CVD technique; a mixture gas, e.g., a mixture of $SiH_4$ and He, is passed over the silicone wafer, which is heated to about 600°C, for a period of several minutes to several tens of minutes whereby a polysilicon film is grown on the back face of the silicon wafer.

When such PBS wafer is subjected to a high temperature heat treatment, gettering is effected such that the heavy metal impurities contained in the wafer such as Cu and Ni are absorbed and captured by the polysilicon film. For example, a boat carrying a plurality of PBS wafers is introduced into a horizontal furnace, which is heated to 900°C, and the PBS wafers are heated in a nitrogen gas atmosphere for thirty minutes (ref. Fig. 1). In each silicon wafer, heavy metal impurities such as Cu and Ni are picked by the polysilicon film while Fe remains in the single crystal body.

The present inventors considered that gettering by polysilicon film of Fe, whose diffusion coefficient is relatively low, takes place only at lower temperatures, and they, therefore, tried to estimate the temperature at which Fe gettering occurs (critical temperature), that is, the temperature at which iron starts separating in the polysilicon film. Parameters required for this estimation are temperature dependency of the Fe diffusion coefficient in Si, cooling rate of PBS wafer, and the amount of Fe involved in the gettering. Calculations were conducted based on these parameters, and as the result, the inventors obtained 710°C as the estimated critical temperature for Fe gettering to start.

The inventors further confirmed the precision of the estimation (710° C) through experiments.

In the experiments, PBS wafers obtained by contaminating the mirror face of each silicon wafer with iron by means of the spinner method were put in a horizontal furnace, where they were kept heated at 1000 °C in an nitrogen gas atmosphere for five hours; as the result, the iron was caused to diffuse in the wafer body; thereafter, the PBS wafers were subjected to a one-hour heat treatment at 900°C in an atmosphere of nitrogen gas. After this, the PBS wafers were gradually cooled at a cooling rate lower than about 3°C/minute such that the temperature decreased along the curve of Fig. 2. One by one five PBS wafers were fetched out of the furnace each time the lowering temperature became 900°C, 800°C, 700°C, 600°C and 200°C, respectively. The diffusion lengths of the minority carriers of the PBS wafers, which were fetched out at different temperatures, were measured by means of the surface photoelectric voltage (SPV) method to thereby obtain the Fe gettering efficiency. The result obtained is shown in Fig. 3. Incidentally, after several repetitions of the same experiment, it was confirmed that the gettering result was highly reproducible.

Fig. 3 clearly shows that the gettering efficiency was higher when the fetching temperature was lower. Also, Fig. 3 indicates that the substantial gettering started when the temperature was in the vicinity of 710°C, and that when the temperature became about 400°C and lower, no further substantial gettering ensued so that further cooling brought about no substantial improvement in the gettering efficiency. Fig. 3 teaches that the optimum temperature at which the wafers are fetched out from the furnace should be in the range of from 400°C to 600°C.

Besides, if the wafers are allowed to cool to considerably low temperatures before being fetched out from the furnace so as to optimize the gettering efficiency, then this would require a considerable cooling time, as suggested by Fig. 2, and such time-consuming operation will result in extremely low productivity.

Therefore, a desirable practical range of fetching temperature, allowing such ambiguous factors as the temperature distribution in the furnace and errors in temperature measurement, is from 400°C to 800°C.

Of course, it was observed that certain modicum degree of gettering had taken place in a PBS wafer which was fetched out from the furnace at a temperature exceeding 800°C.

In the present embodiment, as shown in Fig. 1, when the heat treatment at 900°C was completed, the PBS wafers were allowed to gradually cool to a temperature lower than 700°C, as shown in Fig. 1, and only after this the PBS wafers were fetched out from the furnace, and thus a substantially high Fe gettering efficiency was attained.

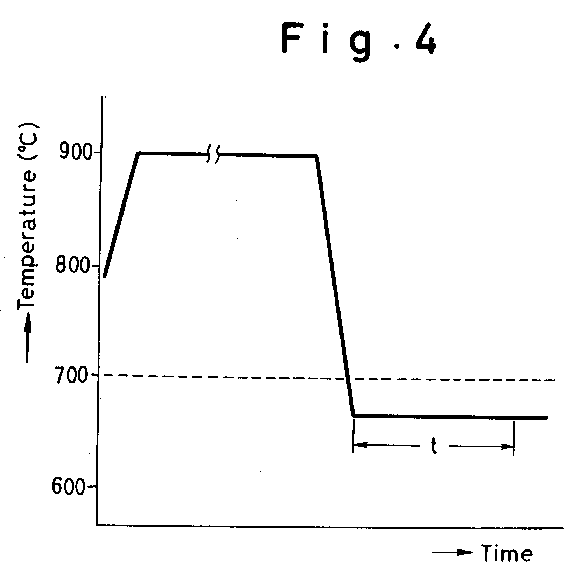

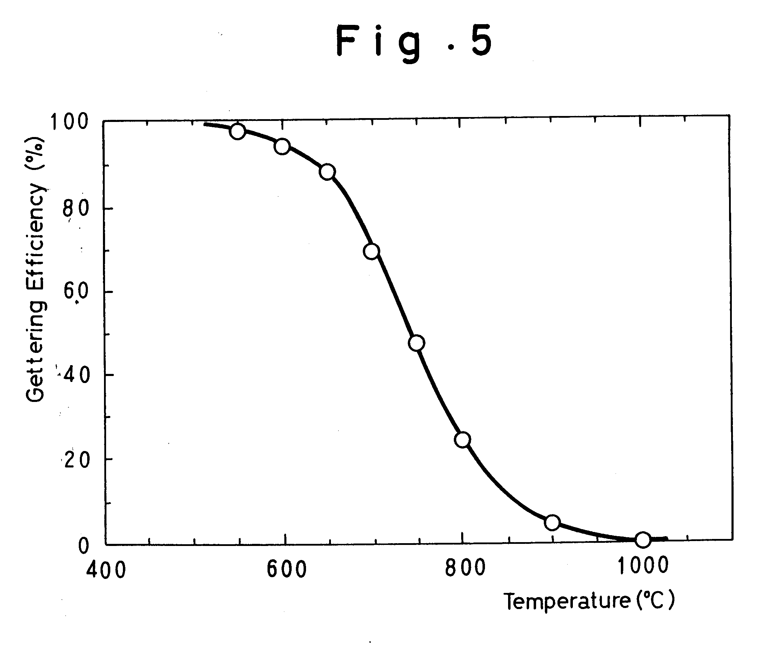

Next, a second embodiment of the invention will be described with reference to Fig. 4 and Fig. 5. Fig. 4, incidentally, is a graph showing a temperature variation pattern with time in the heat treatment according to the second embodiment of the invention, and Fig. 5 is a graph showing a relation between gettering efficiency and the temperature at which the wafers were retained.

In the second embodiment, as shown in Fig. 4, PBS wafers were first subjected to a heat treatment at 900°C, and then they were retained in the furnace for a predetermined time length t during which the furnace temperature was maintained at different fixed temperatures in the range of from about 400°C to about 1,000°C, and thereafter the wafers were fetched out from the furnace.

According to experiments at isothermal heat treatment, it has been found that if the Fe diffusion length ( $\mu$m) is controlled to the level of wafer thickness Ws ( $\mu$m), the gettering will proceed until equilibrium state is almost reached. Now, the Fe diffusion length is given as follows:

$$[Fe \ diffusion \ length] = (D \cdot t)^{1/2}$$

wherein D is a diffusion coefficient ($\mu$m²/minute) and t is the retention time (minute). Hence, the time length t over which the PBS wafers ought to be retained in the furnace at a temperature in the range of from about 400°C to about 800°C (desirably not higher than 700°C) is a value that satisfies the following semi-equation:

$$(D \cdot t)^{1/2} \fallingdotseq Ws.$$

Incidentally, the thickness Ws of the PBS wafers used in these experiments was 515 $\mu$m (of which 1.1 $\mu$m was the thickness of the polysilicon film), and these PBS wafers were contaminated beforehand by Fe diffusion, like the PBS wafers of the first embodiment.

Thus, after the heat treatment at 900°C, the Fe-diffused PBS wafers were retained in the furnace for a predetermined time period t (which is of such a length that the Fe diffusion length becomes nearly equal to 780 $\mu$m, which is about 1.5 times the thickness Ws of the PBS wafer) during which the furnace temperature was maintained at different constant values in the range of from 550 to 1,000°C. Thereafter, the PBS wafers were fetched out from the furnace, the diffusion lengths of the minority carriers with respect to individual wafers were measured by means of the surface photoelectric voltage (SPV) method, and from the measurement results the Fe gettering efficiencies were obtained.

The results of these experiments relative to the second embodiment were as shown in Fig. 5. The results suggest that the effective retention temperature is in the range of from about 400 to about 800° C; however, it was also confirmed that a preferable retention temperature range is from about 400°C to about 700°C. Fig. 5 also indicates that the lower the retention temperature the higher the gettering efficiency.

*Results of the Invention*

As is clear from the above description, according to the invention, a silicon wafer whose back face is lined with a polysilicon film, is first subjected to a conventional heat treatment conducted at about 900°C, and, thereafter, either the silicon wafer is cooled to a temperature in a range of from about 400°C to about 800°C at a cooling rate of not greater than 3°C/minute, or the silicon wafer is kept heated at a fixed temperature selected from a range of from about 400°C to about 800°C for a predetermined time length which is obtained by consideration of the semi-equation $(D \cdot t)^{1/2} \fallingdotseq Ws$, which relates the time length t to the wafer thickness Ws. Consequently, it is now possible to effect Fe gettering to a substantially improved degree, and thus the Fe concentration in the silicon wafer is effectively lowered.

Obviously many modifications and variations of the present invention are possible in the light of the above teachings. It is therefore to be understood that within the scope of the appended claims the invention may he practiced otherwise than is specifically described.

**Claims**

1. A method for heat treating a single crystal silicon wafer whose back face is covered with a polycrystal silicon film comprising the steps of: (a) heating the wafer at a temperature substantially higher than 800°C in an inert atmosphere, and (b) cooling the wafer to a temperature selected from a range of about 400°C to about 800°C.

2. The method as claimed in Claim 1 wherein said silicon wafer is cooled at a rate of less than about 3°C per minute.

3. The method as claimed in Claim 2 wherein said selected temperature is from about 400°C to about 600°C.

4. The method as claimed in Claim 1 wherein said silicon wafer is kept at said selected temperature for a predetermined period of time.

5. The method as claimed in Claim 4 wherein said predetermined time period is such that the value of $(D \cdot t)^{1/2}$ is either roughly equal to or greater than the thickness of the silicon wafer, D representing the diffusion coefficient of iron and t said predetermined time period.

6. The method as claimed in Claim 5 wherein said selected temperature is from about 400°C to about 700°C.

# Fig.1

Fig. 2

# F i g . 3

EP 0 562 783 A1

Fig. 4

9

# Fig · 5

**European Patent Office**

# EUROPEAN SEARCH REPORT

Application Number

EP 93 30 2118
PAGE1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | DD-A-222 449 (AKAD. DER WISSENSCHAFTEN DER DDR, INST. FUR PHYSIK DER WEKSTOFFBEARBEI)<br>* page 1; claim 1 *<br>--- | 1-6 | H01L21/324<br>H01L21/322 |
| Y | JOURNAL OF APPLIED PHYSICS.<br>vol. 64, no. 12, 15 December 1988, NEW YORK US<br>pages 6716 - 6720<br>M.S. GOORSKY ET AL. 'The contrastive behavior of Fe and Cr during the intrinsic gettering of silicon'<br>* page 6716, right column *<br>* page 6717, paragraph III; figures 1A,1B,2; table I *<br>* page 6718, paragraph IV *<br>--- | 1-6 | |
| A | EP-A-0 120 830 (MONSANTO COMPANY)<br>* page 1, line 4 - line 22 *<br>* page 5, line 19 - page 6, line 14 *<br>* page 13, line 17 - line 30; claims 1,7 *<br>--- | 1 | |
| A | DATABASE WPI<br>Week 7745,<br>Derwent Publications Ltd., London, GB;<br>AN 77-80318Y<br>& JP-A-52 116 079 (HITACHI K.K.) 29 September 1977<br>* abstract *<br>--- | 1,2 | TECHNICAL FIELDS SEARCHED (Int. Cl.5)<br><br>H01L |
| A | JOURNAL OF THE ELECTROCHEMICAL SOCIETY<br>vol. 129, no. 6, June 1982, MANCHESTER, NEW HAMPSHIRE US<br>pages 1294 - 1299<br>M.C. CHEN ET AL. 'Post-epitaxial Polysilicon and Si3N4 gettering in Silicon'<br>* page 1294 - page 1295, left column; figure 1 *<br>* page 1296, right column; figure 8 *<br>--- | 1 | |

The present search report has been drawn up for all claims

| Place of search | Date of completion of the search | Examiner |
|---|---|---|
| BERLIN | 08 JUNE 1993 | KLOPFENSTEIN P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

EP 0 562 783 A1

**European Patent Office**

**EUROPEAN SEARCH REPORT**

Application Number

EP    93 30 2118
PAGE2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | DD-A-232 138 (HUMBOLDT-UNIVERSITÄT ZU BERLIN, DIREKTORAT FÜR FORSCHUNG) * page 1 * | 1,5 | |
| P,A | PATENT ABSTRACTS OF JAPAN vol. 16, no. 542 (E-1290)12 November 1992 & JP-A-42 07 036 ( FUJITSU LTD. ) 29 July 1992 * abstract * | 1,3-6 | |

TECHNICAL FIELDS SEARCHED (Int. Cl.5)

The present search report has been drawn up for all claims

| Place of search | Date of completion of the search | Examiner |
|---|---|---|
| BERLIN | 08 JUNE 1993 | KLOPFENSTEIN P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

12